# EUROPEAN PATENT SPECIFICATION

(11) **EP 2 109 350 B1**
(45) Date of publication and mention of the grant of the patent: **23.06.2010**
(21) Application number: 09159282.4
(22) Date of filing: 02.09.2004
(51) Int. Cl.: H05K 3/12, H01L 51/40, B41J 3/407, B29C 67/00

(54) **System for creating fine lines using inkjet technology**
System zur Schaffung feiner Linien mittels Tintenstrahltechnologie
Système pour la création de lignes fines avec la technologie de jet d'encre

(30) Priority: 02.09.2003 US 499099 P
(43) Date of publication of application: 14.10.2009
(62) Divisional of application: 04770463.0
(73) Proprietor: PIXDRO LTD., 93502 Jerusalem (IL)
(72) Inventor: Vronsky, Eli, 47212, Ramat Hasharon (IL)
(74) Representative: Hatzmann, Martin

(56) References cited:
- WO-A-03/004280
- GB-A- 2 350 321
- GB-A- 2 379 414
- US-A1- 2003 083 203

## Description

### FIELD OF THE INVENTION

The invention relates to inkjet technology.

### BACKGROUND OF THE INVENTION

In the production of electronic basic structures, such as printed circuit boards, color filters for liquid crystal displays and semiconductors, a technology which is commonly used involves patterned masks similar in principle to those used in lithographic printing for preparation of printing plates.

A substrate is coated with photosensitive material which is then cured by light. The coating is done by simple dipping or by spin coating when the layer is desired to be very thin. Light is then projected on to the photosensitive layer through a mask which was prepared in advance with a desired pattern. The light which is projected on the photosensitive layer cause it to harden or "cure" at the exposed areas. The non-hardened part, not exposed to light, is washed then away, leaving a desired pattern of hardened layer. Owing the miniaturization of circuit boards, or the required optical precision of color filters there is a demand to create lines as thin as 10 micrometers or less. This is achievable by refined masks and light sources as well as improved curable materials.

The lithographic process is expensive for two reasons:
- a large portion of the photosensitive material is washed out after curing; and
- each pattern requires its own mask which have to be prepared in advance.

In the printing industry inkjet technology is used to eliminate the need of printing plates as ink droplets are placed directly on a substrate without a mask and under digital control. Thus patterns can be created, changed or replaced on the fly.

Thus, an attractive alternative to masks used to print the photosensitive curable material in the electronic industry is to print patterns of such materials using an inkjet mechanism, thus eliminating the need for masks and moreover using only a small quantity of photosensitive material in comparison to lithography. The smaller amount of material is because it is used only where needed and avoids the need to coat the total surface of the substrate. As some curable materials can be rather expensive when mass production is considered, it should be expected that savings using inkjet printing ought to be substantial. WO-A-02 03322 discloses an example of the use of inkjet printing for the formation of electrical conductors on a substrate.

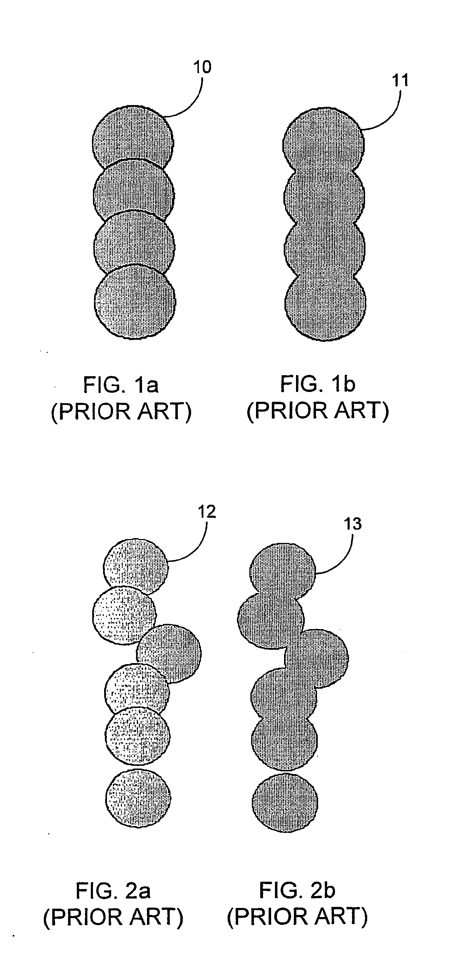

However, printing fine straight lines by inkjet technologies is a complicated task. Fig. 1a shows a line created using inkjet printing by sequentially juxtaposing ink droplets 10 along a line. Owing to the circular shape that the droplets 10 assume on the substrate, the result on drying as shown in Fig. 1b will be a jagged line 11 that is not as fine as required and has a non-uniform edge.

The reasons for this are multiple:
1. Using even tiny droplets it is very difficult to create lines of less than 20um.
2. Even if such lines could be achieved by inkjet, the effects of surface tension and surface energy of the substrate and local contamination will create unevenness in drop expansion and increase the non-uniformity of the line.
3. When the directionalities of the droplets' placements are slightly out of phase (a common phenomenon in inkjet printers, where directionality is varied by few milliradians at least), the resulting line appears crooked. This is shown in Figs. 2a and 2b, where very minor variations in the directionality of droplets 12, along both X and Y axes contribute to the unevenness of the line edge of the resulting pattern 13.

Furthermore, attempting to use conventional ink-jet techniques, particularly when very thin lines are required, requires expensive, off-line correction of defects such as pin holes which can render a line to be non functional. This, of course, is all the more critical when the lines are used to form electrically conductive tracks in a PCB since such pin holes may be manifested as open circuits.

Owing to the simplicity of ink-jet techniques, their profusion and low-price, it would be a significant benefit if ink-jet technology could be used to produce the fine lines required for the fabrication of electronic devices without being subject to the drawbacks described above.

### SUMMARY OF THE INVENTION

It is therefore an object of the present invention to provide an apparatus for producing the fine lines required for the fabrication of electronic devices using ink-jet technology that are not subject to the drawbacks described above.

This object is realized in accordance with one aspect of the invention by an inkjet printing system for producing a geometry of desired dimension on a substrate comprising:
- a first nozzle configured to drop successive droplets of a material on to the substrate so as to form a pattern that is of sufficient dimension to accommodate said geometry within a boundary thereof; and
- a laser disposed downstream of the first nozzle configured for curing or drying a portion formed within a boundary of successive droplets thus creating a removeable redundant area of the pattern that surrounds said portion of said pattern defining said geometry;.or
- a laser disposed downstream of the first nozzle configured for ablating redundant areas of the pattern that surrounds said portion of said pattern defining said geometry.

In an embodiment the inkjet printing system may comprise:
- an optical detector disposed downstream of the first nozzle for detecting whether the first nozzle placed a first droplet of inkjet material in an acceptable manner;
- an auxiliary nozzle disposed downstream of the optical detector; and
- a controller coupled to the optical detector and to the auxiliary nozzle and being responsive to the optical detector detecting that the first nozzle did not place a droplet of inkjet material in an acceptable manner for controlling the second nozzle to eject a second droplet to replace or complete the first droplet.

The geometry may simply be a fine line and the disclosure describes two major solutions that enable creation of very fine lines, or any other geometry, of photosensitive curable material.

A first approach employs a hybrid system containing an inkjet printing system and a laser system. The inkjet printing system prints an ink which is curable by light of a predetermined wavelength (for example infrared curable ink from IR laser or UV curable ink with UV laser). The invention proposes three ways of achieving the solution for inkjet deposition of photosensitive curable material which is followed by curing it with light.

According to a second approach, parallel lines of reacting materials are printed, lines or patterns being created at the areas of reaction.

In addition, the disclosure also provides means to check and repair line defects that might be due to missing or misdirected drops.

### BRIEF DESCRIPTION OF THE DRAWINGS

In order to understand the invention and to see how it may be carried out in practice, a preferred embodiment will now be described, by way of non-limiting example only, with reference to the accompanying drawings, in which:
Figs. 1a and 1b are pictorial representations of a line formed of a series of juxtaposed ink droplets using conventional inkjet technology;
Figs. 2a and 2b are pictorial representations of a line formed of a series of juxtaposed ink droplets when subject to additional distortions inherent in ink-jet technology;
Figs. 3a to 3c are pictorial representations showing successive stages in the formation of lines produced by an inkjet assisted process followed by laser curing;
Figs. 4a to 4g are pictorial representations showing successive stages in the formation of lines produced by an inkjet assisted process followed by etching;
Figs. 5a to 5g are pictorial representations showing successive stages in the formation of lines produced by a lithographic assisted process followed by etching;
Figs. 6 and 7 are pictorial representations of alternative systems according to the invention;
Figs. 8a to 8d and 9a to 9d are pictorial representations showing successive stages in the formation of lines at areas of reaction between parallel lines of reacting materials according to alternative approaches ; and
Figs. 10a to 10c are pictorial representations showing successive stages in the formation of lines produced by ablation of juxtaposed inkjet droplets.

### DETAILED DESCRIPTION OF EXEMPLARY EMBODIMENTS

### Combined use of inkjet printing and of curing by focused laser beam

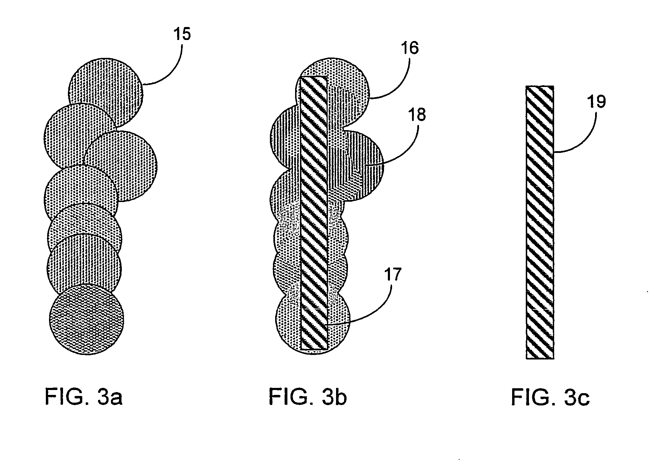

As seen in Figs. 3a and 3b, photosensitive curable material is deposited as a line by inkjet heads containing at least one nozzle. The photosensitive curable material is prepared in advance to have suitable viscosity and surface tension, so it will be easily ejectable and will spread satisfactorily over the substrate.

The inkjet prints a series of juxtaposed ink droplets 15 so as to form a pattern 16 that, with all the distortions as described above with reference to Figs. 1 and 2, leaves sufficient room for a fine line of desired width to be cured within the inked pattern. As shown in Fig. 3b, a laser beam of a desired focus, down to few microns, or in the nanometers range, is moved over the wet ink so as to cure or dry it only in that portion 17 of the pattern 16 where the beam was projected. The surrounding ink residue 18 that is not cured or dried is flushed out so as to leave a fine line 19 with sharp edge on the printed substrate as shown in Fig. 3c.

The laser beam is of a specific wavelength that is known to cure the ink. Some inks are cured by light at the ultraviolet wavelengths, others are cured by light at the infrared wavelength. It is also possible to use inks that are hardened by light at visible wavelengths, but the process will then be complicated by having to be done in the dark.

Such a method can be used for example to print a black matrix for LCD displays where very thin straight lines with width of 10 µm have to be printed. Most manufacturers currently achieve this by lithography. The method according to the invention results in a reduction of the amount of photosensitive curable ink required, printing first inkjet lines which are only several tens of microns wide and having these lines then shaped by laser curing the final straight lines with a required width of 10 µm. The uncured photosensitive material is then flushed out of the substrate by washing.

According to another approach, very fine lines are created using electrically conductive polymers. Currently several companies such as Epson of Japan are trying to construct electronic conductors not with conventional conducting materials but with polymers of high electrical conductivity. Such polymers are ejectable by inkjet mechanisms. Of these polymers, those that are curable and hardened by a precise light source such as a laser can be printed into fine precise lines according to the teaching of the invention. The invention thus paves the way to print conductors with inkjet technology and replace the conventional lithographic techniques.

The same proposed technology of the invention, inkjetting followed by laser curing can be applied to production of Thin Film Transistor (TFT) electronics used in manufacturing of flat panel displays and more generally in other facets of electronic manufacturing. Currently TFT multilayer structures are produced with lithographic techniques that are well-known in the semiconductor manufacturing industry. The lithographic processes are used to create patterns that allow the creation of the complex multilayer structures by selective etching, coating or depositions. The patterns created for those purposes are not only lines but also other geometrical forms. According to the invention, such geometrical forms can be generated by first inkjetting a gross outline, and then bringing them into a final desired form by focused beam laser curing. The operation of the laser beam can be continuous or pulsed, and its movement across the area of the inkjetted curable material can be programmed. This coupled with programmable intensity control of the beam, provides a high degree of flexibility in the creation of desired lines or shapes.

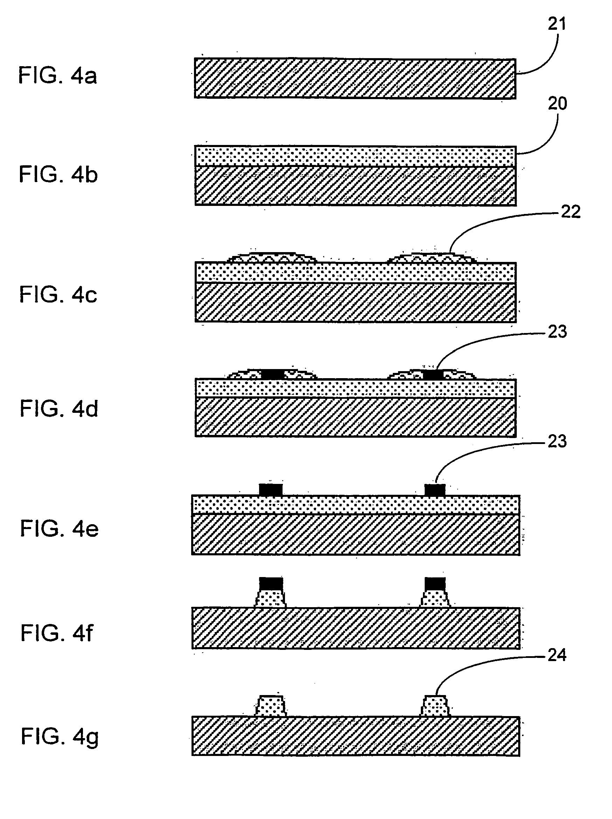

Figs. 4a to 4g are pictorial representations showing successive stages in the formation of lines produced by an inkjet assisted process followed by etching. By such means, it is possible to allow etching of a selective layer within the multilayer structure of a TFT. The figures depict the etching of an "active" layer of such a structure. This active layer might be a conductive material that has to be shaped so that conductivity will be confined only to parts of the layer. The example shows how in successive stages, an active layer 20 is coated on a substrate 21, whereafter inkjetted patterns 22 of photosensitive curable material are formed on the active layer (Fig. 4c). Laser light is focused on the photosensitive curable material so as to expose a pattern of fine lines thereon. Where the laser light strikes the photosensitive curable material, the lines are cured to form the desired patterns 23 (Fig. 4d). The uncured material is then flushed (Fig. 4e) and those areas of the active layer that are not covered by cured material are then etched (Fig. 4e). After etching is completed, the pattern made of the cured material is removed either chemically or using any other suitable method. This process will result in an active layer formed into a precise pattern 24 as shown in Fig. 4g. Those familiar with the art will understand that using the process of the invention will save on photosensitive curable material since there is no need to coat the complete surface of the active layer with photosensitive curable material as is conventionally done. The process of the invention will also simplify removal and cleaning of the photosensitive uncurable material, since there is less of it, and thus be less prone to defects.

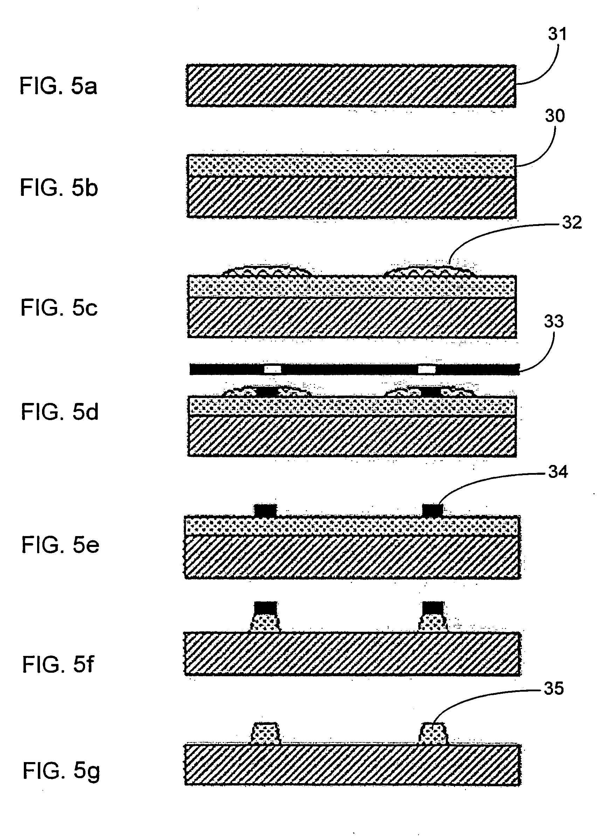

Figs. 5a to 5g are pictorial representations showing successive stages in the same process using lithography. Thus, in successive stages, an active layer 30 is coated on a substrate 31 and layers of photosensitive curable material 32 (Fig. 5c) are applied by an inkjet process. There is no need to coat the entire area of the substrate since it is sufficient that only those areas where lines are to be formed be coated and this lends itself to inkjet printing. By such means, the quantity of photosensitive curable material used may be significantly reduced as compared with conventional lithographic processes where the complete area of the substrate is coated by dipping or spinning. A mask 33 is used to expose a pattern of fine lines on the photosensitive curable material to light so as to cure the desired patterns (Fig. 5d). The uncured areas of the photosensitive curable material 32 are then flushed so as to reveal the pattern of lines 34 (Fig. 5e). Those areas of the active layer that are not covered by cured material are then etched (Fig. 5f). After etching is completed, the pattern made of the cured material is removed either chemically or using any other suitable method. This process will result in an active layer formed into a precise pattern 35 as shown in Fig. 5g.

In addition to the formation of accurate lines, both of these methods are applicable to other geometric forms which are first delineated as a gap in non-curable, non adhering material, this gap being then printed over with curable material. When the substrate is flushed or washed, only the material in the area of the primary gap will be left on the substrate. Thus, in the context of the description and the appended claims the term "geometry" is used to imply any filled shape that may be regular or irregular. It is also to be noted that the term "line" is used to imply any extent of length that is straight, angled or curved or any combination of these properties.

### Reliability issues

One of the major obstacles in inkjet printing is the nozzle reliability. Nozzle reliability can come in several forms:
- Soft failure (nozzle does not work but can be restored in a maintenance process)
- Hard failure (nozzle is permanently unusable)
- Missed directionality
- Smaller drop volume

Having very thin lines with defects can render them non-functional. In the case of color filters mentioned above used in an offset printing process, even a slight defect in the black matrix cells can result in a mixture of two different colors in an adjacent cell rendering defective the picture element they filter.

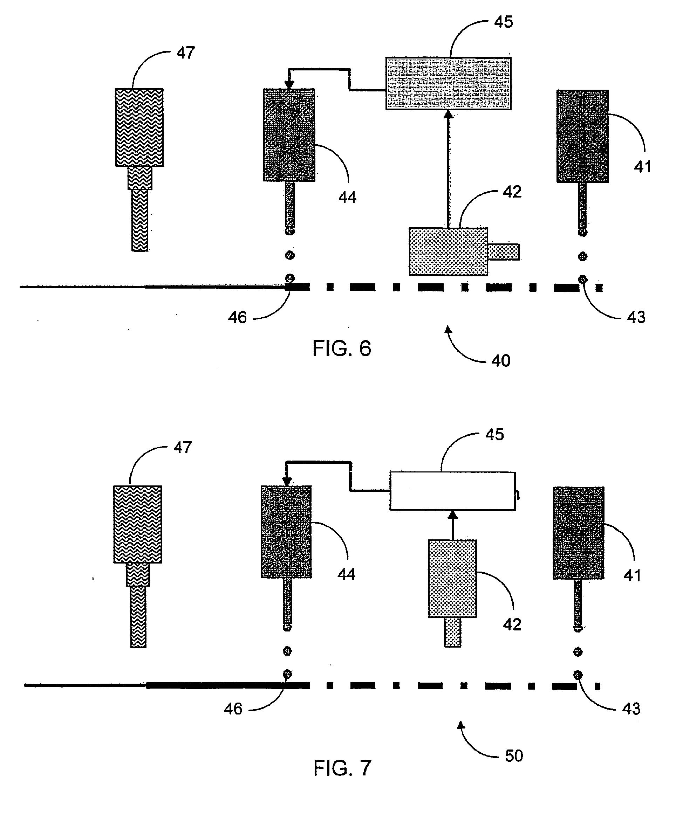

The first method of the invention yields itself to achieving an increased process reliability, correcting to a degree the above mentioned problems. This is achieved by the systems 40 and 50 shown schematically in Figs. 6 and 7, respectively and in which like components are referenced by identical reference numerals. Thus, both systems 40 and 50 include a printing nozzle 41 (constituting a first nozzle), downstream of which there is disposed an optical detector 42, which detects whether the printing nozzle 41 did actually eject a droplet. The detection can be done by looking into the path of the printing nozzle 41 or of a droplet 43 formed thereby as shown in Fig. 6 so as to detect an actual droplet "on the fly", or by looking at the substrate for the actually printed dot as shown in Fig. 7. If the printed dot were not placed or were not placed in the right position, an auxiliary nozzle 44 (constituting a second nozzle) controlled by a controller 45 which is responsively coupled to the optical detector 42 and operates in accordance with a predetermined control algorithm ejects a second droplet 46 to replace or complete the first droplet 43. A laser 47 downstream of the second nozzle 44 cures or dries the printed image according to the desired pattern. The continuity of the process is achieved by the geometry of the correct relative placement of the first nozzle 41, the detector 42, the second nozzle 44 and the laser 47 and relative movement between the substrate and the print system. The droplets may be cured directly after their placement on the substrate or cured after the ink pattern is completely formed.

Another approach is to employ one or more redundant nozzles for printing the pattern so as to increase the probability that the geometry of the desired pattern will appear intact thus providing on the substrate a pattern of sufficient dimension for the laser action. This is a far simpler solution to implement because the exact shape of the inkjetted line is not crucial as long as this line is continuous. The exact shaping may be achieved by the laser curing.

### Creating fine lines by using two materials that are cured by chemical reaction

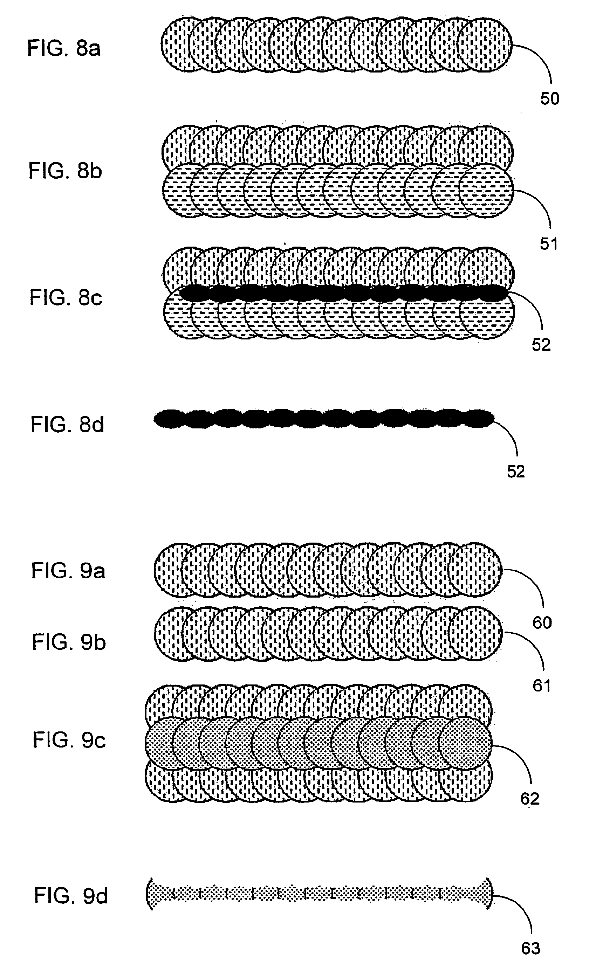

Figs. 8a to 8d are pictorial representations showing successive stages in the formation of lines at areas of reaction between parallel lines of reacting materials according to a first approach. In this method a first line 50 with first material is printed, then a second, parallel, line 51 of second material is printed which overlaps the first line so as to form an overlapping area 52. The first and second lines are formed of materials that react on contact via a chemical or physicochemical reaction that cures the lines where they contact (as in epoxy glues) while having no effect on those areas of the two lines that do not overlap. The reaction is limited therefore to the overlapping area 52 only, and the remains, which are not cured, are flushed after a controlled time (to prevent over curing).

Figs. 9a to 9d are pictorial representations showing successive stages in the formation of lines at areas of reaction between parallel lines of reacting materials according to a second approach. In this method, first and second lines 60 and 61 formed of a first material that may be flushed in known manner are printed on a substrate. A third, parallel, line 62 of a second material is printed which overlaps the first and second lines so as to cover an intervening space 63 between the two lines 60 and 61. The second material is such that in its normal state it cures in air after a known curing time that may be influenced by ambient temperature. Likewise, it may be formed of a material that can be dried or cured in known manner e. g. by light, heat, etc. By such means, the space 63 between the two lines 60 and 61 is filled by the curable second material of the third line 62, which is allowed to cure and adhere to the substrate. The substrate is then washed so as to flush the first and second lines 60 and 61 together with the remaining portions of the third line 62 with which they overlap. It does not matter if the portions of the third line 63 overlapping the two lines 60 and 61 are also allowed to cure providing it remains possible to flush away the first and second lines entirely since, in doing so, the cured portions of the third line will likewise be disposed of.

However, if desired, the second material may be such that on contact with the first material of the first and second lines 60 and 61 it reacts via a chemical or physicochemical reaction that prevents curing of the second material, while having no effect on that area of the third line that does not overlap the first and second lines, i. e. within the space 63. By such means it may be easier to flush away the redundant material.

### Creating fine lines with inkjet by overlapping separate colored inks

This method applied to color filters only and may be used in conjunction with one of the other methods described above to generate many different shapes. This method uses the three primary colors (RGB) to create the black matrix used to separate between the colors. The working process is similar to that described above with reference to Fig. 8.

In the first stage a first RGB color is printed. In a second stage a second RGB color is printed to overlap the first one. Every two colors create a chemical reaction between the overlapping areas such that the overlapping areas are converted to black. In this way the black matrix is created at every border between colors. In a final stage the colors are cured or dried. Such a method may be used in color offset printing, for example in the manufacture of color displays such as LCDs, whereby the three RGB components of each pixel can be printed using an inkjet while ensuring that any overlap is black.

### Combined use of inkjet printing and of ablation by focused laser beam

The principle described above with reference to Figs. 3a to 3b of first creating a gross line or shape by inkjetting and then tailoring the precise form by laser can also be employed where the laser beam is used to ablate parts of the ink.

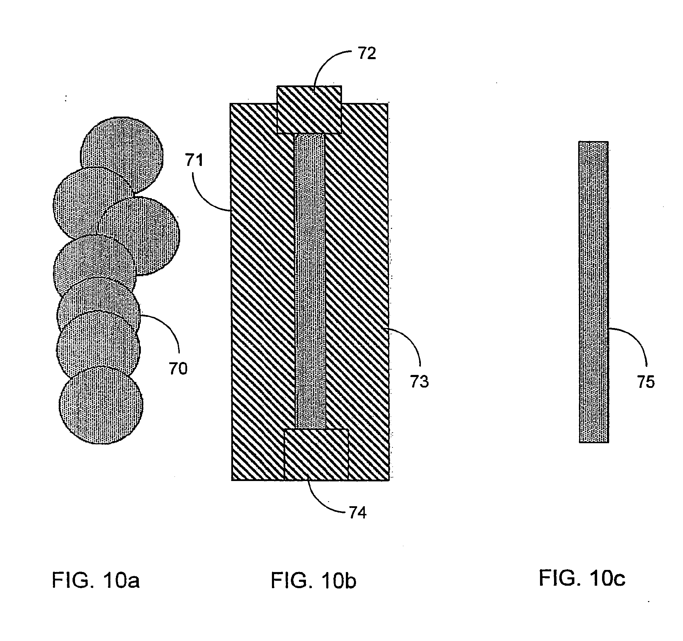

Figs.10a to 10c are pictorial representations showing successive stages in such a process. A line of material 70 which can be ablated by laser beam is printed. A laser beam is used to ablate it on all four sides so as to remove the areas 71, 72, 73 and 74. By such means, what remains on the substrate is a fine and precise line 75 having fine edges and a desired width. An excimer laser, for example can be used to create controlled and precise ablation.

### Other fields where the principles of the invention can be applied

Although the invention has been described with particular regard to the formation of fine lines, it is to be understood that the principles of the invention are applicable to any geometrical shape. For example, while it known to manufacture PCBs using an artwork that defines the circuit pads and conductive tracks and which is typically used as a mask through which the active layer of the PCB is exposed to light, the invention allows the artwork to be drawn directly on the PCB thus avoiding the need for a mask. In such an approach the active layer (typically copper) is first covered with photosensitive curable material so that the exposed portions are cured. The uncured material is then flushed thus exposing all those areas of the active copper layer that are redundant, allowing these to be etched without affecting those areas of the active copper layer that are to be preserved. In such an approach much of the active layer is disposed of.

However, the principles of the invention allow the copper tracks and pads (i.e. artwork) to be drawn directly on to an insulating substrate using an electrically conductive ink that is applied using inkjet technology, allowing surplus ink to be removed either by curing those areas that are to be preserved and flushing the remainder; or by ablating the redundant areas either prior to or subsequent to curing the remaining material. Such an approach requires far less surplus conductive material to be removed.

## Claims

1. An inkjet printing system (40,50) for producing a geometry (19, 24, 35) of desired dimension on a substrate comprising:
• a first nozzle (41) configured to drop successive droplets (43) of a material on to the substrate so as to form a pattern (16, 22, 32) that is of sufficient dimension to accommodate said geometry within a boundary thereof; and
• a laser (47) disposed downstream of the first nozzle (41) configured for curing or drying a portion (17, 23) formed within a boundary of successive droplets thus creating a removeable redundant area (18) of the pattern that surrounds said portion (17, 23) of said pattern defining said geometry;.or
• a laser (47) disposed downstream of the first nozzle (41) configured for ablating redundant areas (18) of the pattern that surrounds said portion (17, 23) of said pattern defining said geometry.

2. The inkjet printing system according to claim 1 comprising:
• an optical detector (42) disposed downstream of the first nozzle (41) for detecting whether the first nozzle placed a first droplet (43) of inkjet material in an acceptable manner;
• an auxiliary nozzle (44) disposed downstream of the optical detector (42); and
• a controller (45) coupled to the optical detector (42) and to the auxiliary nozzle (44) and being responsive to the optical detector (42) detecting that the first nozzle did not place a droplet of inkjet material in an acceptable manner for controlling the second nozzle to eject a second droplet (46) to replace or complete the first droplet (43).

3. The inkjet printing system according to claim 2, wherein the optical detector (42) is configured to look into a path of the first nozzle (41) or of a droplet (43) formed thereby so as to detect an actual droplet "on the fly".

4. The inkjet printing system according to claim 2, wherein the optical detector (42) is configured to look at the substrate for a printed dot.

## Patentansprüche

1. Tintenstrahldrucksystem (40, 50) zur Herstellung eines geometrischen Gebildes (24, 35) mit gewünschten Abmessungen auf einem Substrat, umfassend:
- eine erste Düse (41), die so konfiguriert ist, dass sie sukzessive Tröpfchen (43) eines Materials auf das Substrat tropft, um so ein Muster (22, 32) zu bilden, das ausreichende Abmessungen hat, um das geometrische Gebilde innerhalb einer Grenze desselben aufnehmen zu können, und
- einen Laser (47), der stromabwärts der ersten Düse (41) angeordnet ist, der zum Härten oder Trocknen eines Teils (17, 29), der innerhalb einer Grenze von sukzessiven Tröpfchen gebildet wird, konfiguriert ist, wodurch ein entfernbarer redundanter Bereich (18) des Musters gebildet wird, der den Teil (17, 29) des Musters umgibt, der das geometrische Gebilde definiert, oder
- einen Laser (47), der stromabwärts der ersten Düse (41) angeordnet ist, der zum Ablatieren redundanter Bereiche (18) des Musters, die den Teil (17, 23) des Musters umgeben, der das geometrische Gebilde definiert, konfiguriert ist.

2. Tintenstrahldrucksystem nach Anspruch 1, umfassend:
- einen optischen Detektor (42), der stromabwärts der ersten Düse (41) angeordnet ist, zum Detektieren, ob die erste Düse ein erstes Tröpfchen (43) von Tintenstrahlmaterial in einer annehmbaren Weise platziert hat;
- eine Hilfsdüse (44), die stromabwärts des optischen Detektors (42) angeordnet ist, und
- eine Steuereinheit (45), die mit dem optischen Detektor (42) und der Hilfsdüse (44) verbunden ist und auf den optischen Detektor (42) reagierend ist, der detektiert, dass die erste Düse ein Tröpfchen aus Tintenstrahlmaterial nicht in annehmbarer Weise platziert hat, zur Steuerung der zweiten Düse, um ein zweites Tröpfchen (46) auszustoßen, um das erste Tröpfchen (43) zu ersetzen oder zu vervollständigen.

3. Tintenstrahldrucksystem nach Anspruch 2, wobei der optische Detektor (42) so konfiguriert ist, dass er in den Weg der ersten Düse (41) oder eines Tröpfchens (43), das damit gebildet wird, sieht um ein tatsächliches Tröpfchen "im Flug" zu detektieren.

4. Tintenstrahldrucksystem nach Anspruch 2, wobei der optische Detektor (42) so konfiguriert ist, dass er auf dem Substrat nach einem gedruckten Punkt sucht.

## Revendications

1. Système d'impression par jet d'encre (40, 50) pour réaliser une géométrie (19, 24, 35) d'une dimension souhaitée sur un substrat, comprenant :
- une première buse (41) configurée pour déposer des gouttelettes (43) successives d'un matériau sur le substrat afin de former un motif (16, 22, 32) d'une dimension suffisante à caser ladite géométrie dans les limites d'une frontière de celui-ci ; et
- un laser (47) disposé en aval de la première buse (41) configurée pour durcir ou sécher une partie (17, 23) formée à l'intérieur d'une frontière de gouttelettes successives créant ainsi une zone redondante susceptible d'être enlevée (18) du motif entourant ladite partie (17, 23) dudit motif défini sans ladite géométrie ; ou
- un laser (47) disposé en aval de la première buse (41) configurée pour enlever par ablation des zones redondantes (18) du motif qui entoure ladite partie (17, 23) dudit motif définissant ladite géométrie.

2. Le système d'impression par jet d'encre selon la revendication 1, comprenant:
- un détecteur optique (42) disposé en aval de la première buse (41) pour déterminer si la première buse a placée une première gouttelette (43) de matériau de jet d'encre d'une façon acceptable ;
- une buse auxiliaire (44) disposée en aval du détecteur optique (42) ; et
- un contrôleur (45) couplé au détecteur optique (42) ainsi que à la buse auxiliaire (44) en étant sensible à la détection par le détecteur optique (42) du fait que la première buse n'a pas placée une gouttelette de matériau de jet d'encre d'une façon acceptable, pour commander l'éjection par la deuxième buse d'une deuxième gouttelette (46) pour remplacer ou pour supplémenter la première gouttelette (43).

3. Le système d'impression par jet d'encre selon la revendication 2, dans lequel le détecteur optique (42) est configuré pour examiner un chemin de la première buse (41) ou d'une gouttelette (43) formée par celle-ci, afin de détecter une gouttelette réelle «en vol».

4. Dispositif d'impression par jet d'encre selon la revendication 2, dans lequel le détecteur optique (42) est configuré pour examiner le substrat pour la présence d'un point imprimé.
